Europäisches Patentamt

European Patent Office

Office européen des brevets

(19)

(11) **EP 0 977 365 B1**

(12) **FASCICULE DE BREVET EUROPEEN**

(45) Date de publication et mention
de la délivrance du brevet:
**03.03.2004 Bulletin 2004/10**

(51) Int Cl.⁷: $H03M\ 3/04$, $G01V\ 1/22$

(21) Numéro de dépôt: **99401735.8**

(22) Date de dépôt: **08.07.1999**

(54) **Méthode pour réaliser une compression sans pertes de signaux à grande dynamique**

Verfahren zur verlustfreien Komprimierung von Signalen mit grossem Dynamikbereich

Method for achieving lossfree compression of wide dynamic range signals

(84) Etats contractants désignés:
**DE DK GB NL**

(30) Priorité: **29.07.1998 FR 9809738**

(43) Date de publication de la demande:
**02.02.2000 Bulletin 2000/05**

(73) Titulaire: **Institut Français du Pétrole
92852 Rueil-Malmaison Cedex (FR)**

(72) Inventeurs:
• **Duval, Laurent
92000 Nanterre (FR)**
• **Bui Tran, Van
91300 Massy (FR)**

(56) Documents cités:
**EP-A- 0 002 998** **US-A- 4 571 737**
**US-A- 4 790 015**

**Description**

La présente invention concerne une méthode de transmission de données utilisant des techniques de compression sans pertes, en vue d'optimiser l'utilisation de voies de transmission disponibles.

La méthode selon l'invention trouve des applications notamment dans le domaine de la prospection sismique où il est nécessaire de transférer vers une station centrale telle qu'un camion-laboratoire, une masse souvent considérable de données. Des signaux sont captés par un très grand nombre de récepteurs tels que des géophones disposés couplés avec une formation géologique à étudier, en réponse à des ébranlements émis par une source sismique et renvoyés par les discontinuités du sous-sol. Les signaux captés sont collectés par des unités locales d'acquisition réparties parfois sur une distance de plusieurs kilomètres et destinées chacune à collecter les signaux reçus par un ou plusieurs récepteurs, à les numériser, à leur appliquer des traitements préalables plus ou moins complexes et les stocker dans une mémoire locale avant leur transmission en temps réel ou différé à une station de collecte par une voie de transmission telle qu'un câble, une fibre optique, un canal radio etc.

ETAT DE LA TECHNIQUE

Différents systèmes de transmission de données sismiques sont utilisés pour relier des unités locales d'acquisition à une station centrale soit directement, soit via des stations intermédiaires pourvues de fonctions plus ou moins complexes de concentration ou de contrôle des unités locales. Les liaisons peuvent être assurées au moyen de câbles, de liaisons radio, via un ou plusieurs relais éventuels, ou encore combiner les liaisons par câbles et par liaison radio comme indiqué par exemple dans les brevets FR 2 720 518, FR 2 696 839, 2.608.780, 2.599.533, 2.538.561, 2.511.772 ou 2.627.652 du demandeur.

Par le brevet FR-A-2 608 780 du demandeur notamment, il est connu d'utiliser des boîtiers d'acquisition sismique dotés de deux voies de transmission. l'une à débit de transmission relativement élevé, l'autre à bande passante qui peut être relativement étroite selon la disponibilité locale des fréquences de transmission, plus facilement disponibles dans le cadre des réglementations d'émission radioélectriques en vigueur. Les données sismiques collectées au cours des cycles successifs sont stockées sur une mémoire de masse dans chacun des boîtiers et transférées par intermittence à une station centrale de commande et d'enregistrement. Pour permettre à l'opérateur dans la station centrale de vérifier que l'acquisition des données par chacun des boîtiers d'acquisition se déroule normalement, on procède à une transmission des données partielles ce qui s'accommode bien d'une voie de transmission à bande passante relativement étroite.

Par les brevets FR-A-2 692 384. 2 757 641 et la demande de brevet FR 97/09.547 du demandeur également, il est connu d'utiliser des boîtiers d'acquisition sismique pourvus notamment de moyens de traitement spécialisés dans le traitement des signaux auxquels on fait réaliser de nombreux contrôles des géophones et éléments de la chaîne d'acquisition, des pré-traitements des traces sismiques auparavant réalisés à la station centrale après transmission, adaptés également à appliquer aux données sismiques à transmettre des algorithmes de compression, tous pré-traitements visant à diminuer considérablement le volume de données à rapatrier à la station centrale.

La tendance actuelle, notamment dans le cadre des méthodes d'exploration sismique dites 3D, est à répartir sur une zone à explorer, à terre, en mer, ou dans des zones côtières, souvent sur plusieurs kilomètres, des récepteurs sismiques par centaines, voire par milliers. Le volume des données à collecter et à transmettre ne cesse de croître. Pour éviter que les problèmes de transmission ne constituent un frein à l'évolution des systèmes sismiques la tendance est de recourir à des procédés de compression de données choisis pour être compatibles avec les exigences propres des géophysiciens.

La compression des données sismiques peut apporter à la fois un gain de place appréciable sur les modules de stockage de masse dans les boîtiers locaux d'acquisition et/ou les stations locales de contrôle et de concentration, et aussi un gain considérable en temps de transmission.

Les méthodes connues de compression de données peuvent être classées en deux familles, a) les méthodes de compression sans perte d'information et b) les méthodes conduisant à une perte d'information, les données restituées perdant une part plus ou moins grande de leur précision.

En géophysique notamment, il est indispensable que les pertes dues à la compression restent le plus faible possible car les informations les plus pertinentes sont souvent de très faible amplitude et ne peuvent être isolées du bruit de fond que par un traitement numérique effectué sur plusieurs traces. Des pertes éventuelles de précision ne sont tolérables que dans certains cas bien particuliers, si par exemple l'information transmise ne doit servir qu'à contrôler le bon fonctionnement du matériel et à visualiser "l'allure" des traces échantillonnées.

Parmi les méthodes de la première famille, on peut citer les méthodes qui visent à éliminer la redondance des données ou les méthodes dites à dictionnaire où chaque mot est remplacé par son index dans une table de référence, qui sont d'autant plus intéressantes que les fichiers à compresser contiennent beaucoup de redondance, les méthodes de type RLE pour « Run-Length Encoding », les méthodes de codage de type statistique où l'on cherche à remplacer les données par un code ayant la même signification mais occupant moins de place, les méthodes de type à codage arithmétique qui visent à représenter un nombre variable de données par un nombre constant de bits.

Une technique connue de compression dite «LPC pour « Linear Predictive Coding » est bien adaptée à la compression des ondes acoustiques ou sismiques. Elle consiste essentiellement à remplacer un échantillon de signal s(t) par une prédiction faite à partir de p échantillons précédents, en supposant que le signal est stationnaire. Au lieu de transmettre l'échantillon s(t), on transmet sa prédiction $\hat{s}(t)$ c'est-à-dire les coefficients de prédiction ainsi que les résidus e(t) i.e. l'écart entre la valeur réelle et la prédiction qui en est faite au temps t, ce qui permet de retrouver à la décompression la valeur s(t) = $\hat{s}(t)$ + e(t). Si la prédiction est bonne, les résidus sont faibles et occupent une place moindre que celle des valeurs initiales s(t). Le nombre de coefficients servant à calculer $\hat{s}(t)$ est en général faible et ils occupent peu de place par rapport à s(t).

Cependant, avec ce type de codage. il est conventionnel de ranger les échantillons de traces successifs dans des mémoires-tampons (« buffers ») de taille définie et de calculer des coefficients de prédiction qui sont utilisés pour tous les échantillons d'un même groupe. Il s'avère dans la pratique que ce type de convention est mal adapté aux signaux à grande dynamique comme peuvent l'être les signaux sismiques émis par des sources impulsionnelles (charges de dynamite par exemple), et que des erreurs de codage apparaissent du fait que les coefficients prédictifs choisis ne sont pas bien représentatifs.

La méthode selon l'invention permet de réaliser une compression sans pertes de signaux à grande dynamique. tels que des signaux sismiques, en vue de leur transmission.

La méthode comporte l'échantillonnage des signaux et leur numérisation, et l'utilisation d'une technique de codage prédictif.

Elle est caractérisée en ce qu'elle comporte la détermination d'une plage d'amplitude dépendant d'au moins une valeur seuil (S), qui contient l'essentiel des résidus de prédiction, le codage des résidus de prédiction par des mots binaires ayant un certain nombre de bits suffisant pour le codage de cette plage et le codage des résidus de prédiction dont l'amplitude est en dehors de la plage, par des mots binaires ayant un nombre fixe de bits supérieur à n, et la transmission des seuls résidus de prédiction (les coefficients de prédiction ne sont pas transmis mais recalculés).

Suivant un mode de mise en oeuvre, la méthode peut comporter la détermination d'un facteur d'estimation (S) d'une valeur-seuil optimale correspondant à une moyenne faite à partir de la position des bits de poids forts respectifs de N résidus de prédiction successivement déterminés.

Suivant un autre mode de mise en oeuvre, la méthode peut comporter aussi la détermination de plusieurs plages d'amplitude dépendant de plusieurs valeurs seuils distinctes.

La méthode peut aussi comporter par exemple un codage séparé des bits de poids faibles et forts des échantillons de signaux.

Suivant un mode préféré de mise en oeuvre, la méthode comporte une détermination des résidus de prédiction pour chaque nouvel échantillon de signal.

La méthode selon l'invention est avantageuse dans ses deux étapes prises séparément ou de préférence en combinaison.

    a) la détermination que l'on effectue du nombre de bits au plus nécessaire au codage de la plus grande partie des erreurs, permet de d'obtenir un taux de compression très important même si l'on tient compte du traitement particulier que l'on est amené à effectuer pour coder les erreurs atypiques restantes (peu nombreuses quand la plage de codage est bien choisie);

    b) le codage est ici parfaitement adaptatif puisque les coefficients prédictifs sont calculés à chaque échantillon, ce qui garantit une stabilité des résultats;

D'autres caractéristiques et avantages de la méthode selon l'invention, apparaîtront à la lecture de la description ci-après d'un exemple non limitatif de réalisation, en se référant aux dessins annexés où :

- la Fig.1 illustre la technique connue de prédiction statistique de la valeur d'échantillons d'un signal ;

- la Fig.2 schématise les opérations de compression d'un signal ;

- la Fig.3 schématise les opérations de décompression symétrique d'un signal ; et

- la Fig.4 montre dans le cas d'un codage à un seuil, une plage S d'amplitude choisie pour contenir l'essentiel des résidus de prédiction.

DESCRIPTION DETAILLEE

### I) Codage adaptatif

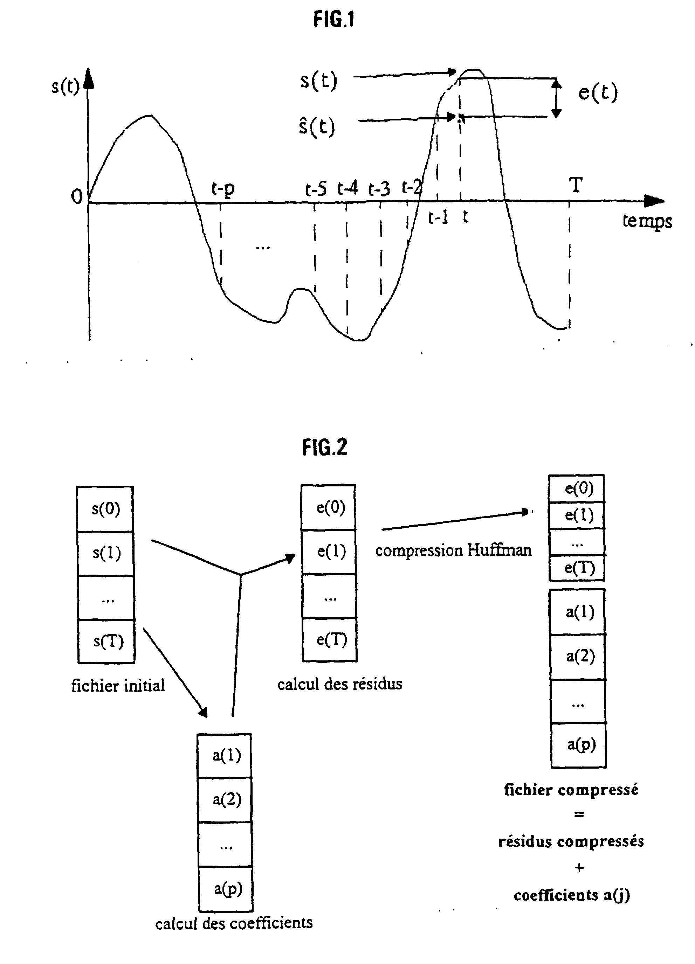

Le procédé selon l'invention comporte l'application aux données à transmettre d'une compression de type sans perte en utilisant la technique prédictive dite LPC où l'amplitude s(t) d'un échantillon de signal à un instant t (Fig. 1) est calculée par une prédiction faite à partir d'un certain nombre p échantillons aux temps (t-1), (t-2), (t-3), ... (t-p), et la valeur prédite est calculée en accord avec la relation suivante :

$$\hat{s}(t) = \sum_{j=1}^{p} a_j \cdot s(t-j) \qquad (1)$$

Au lieu de transmettre l'échantillon, on calcule en ligne les coefficients de prédiction et on transmet les résidus e(t) c'est-à-dire l'écart que l'on calcule entre la valeur réelle s(t) et la prédiction $\hat{s}(t)$ qui en est faite au temps t, ce qui permet de retrouver la valeur s(t) = $\hat{s}(t)$ + e(t) (Fig.2).

Au temps t, les valeurs de s aux temps inférieurs ont déjà été calculées, on connaît de ce fait s(t-j) pour j$\in$ [1, p]. Les valeurs s(t-j) de l'équation (1) qui ne sont pas connues pour t $\in$ [0, p-1] sont remplacées par la valeur 0. L'écart entre le modèle calculé et le signal réel (appelé par la suite erreur de prédiction ou résidu) est codé de façon à réduire la taille moyenne allouée à chaque échantillon (par rapport aux 24 bits initiaux), et à réaliser une compression. Si la prédiction est bonne, les résidus sont faibles et peuvent être codés avec des mots binaires ayant un nombre de bits, du moins en moyenne, bien inférieur généralement à celui servant à coder chaque échantillon s(t) (24 bits par exemple).

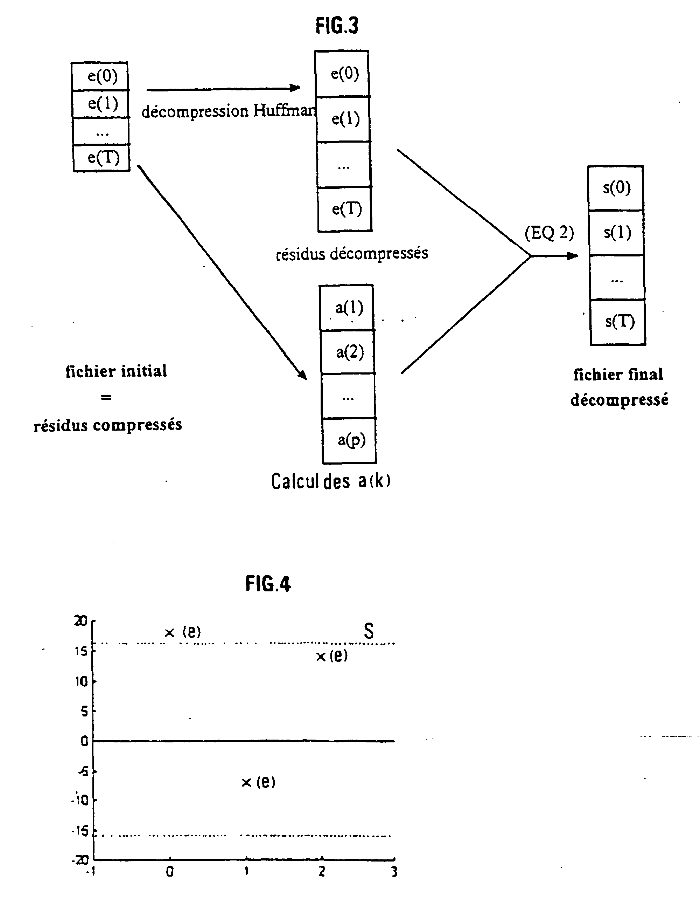

A l'étape de décompression, (Fig.3), le signal est restitué selon la formule suivante :

$$s(t) = \sum_{j=1}^{p} a_j \cdot s(t-j) + e(t) \quad ; \text{avec } t \in [0,T] \qquad (2)$$

Les résidus compressés e(i) du fichier initial sont décompressés et l'on recalcule les coefficients de prédiction a(k) pour chaque échantillon.

De préférence, on réalise une prédiction adaptative : les coefficients $a_1, a_2, ..., a_p$ de prédiction du filtre d'évaluation sont recalculés pour chaque nouvel échantillon, afin de tenir compte de la dynamique souvent très grande des signaux sismiques.

Le procédé selon l'invention offre la possibilité de réduire de façon substantielle la taille des mots binaires de codage de ces résidus. On va décrire ci-après une méthode de codage à un seul seuil, permettant de définir une plage d'amplitude contenant l'essentiel des résidus de prédiction.

### II) Codage des résidus : méthode à un seuil

Si l'on suppose que les erreurs peuvent être codées en valeur absolue sur $N_{max}$ bits et que $N_{max}$ < 23, on réalise un gain en codant chaque erreur sur $N_{max}$ + 1 bits, en comptant le bit de signe. Lors de variations importantes des caractéristiques du signal, des erreurs de prédiction de très forte dynamique peuvent survenir mais elles sont peu fréquentes. On cherche alors à déterminer un seuil S (Fig.4) tel que, pour la plupart des erreurs de prédiction e soit à l'intérieur d'une plage symétrique de valeurs ayant pour bornes $\pm 2^S$ (- $2^S$ < < $2^S$). Les erreurs ou résidus de prédiction à l'intérieur de la plage peuvent être codées sur S + 1 bits (signe compris). Le fichier comprimé contient deux octets codant respectivement $N_{max}$ et S, puis

- Exemple : si l'on a $N_{max}$ = 7, $S$ = 4, $e_O$ = 18, $e_1$ = -7 et $e_2$ = 14, le les erreurs faibles sur S + 1 bits ;

- les erreurs importantes sur $N_{max}$ + 1 bits, précédées par un code préfixe correspondant à

$$-2^S (1 \underbrace{0...0}_{S \ \text{zéros}}).$$

fichier compnmé débutera par la séquence suivante :

$$\underset{N_{max}}{\underline{00000111}} \quad \underset{S}{\underline{00000100}} \quad \underset{code}{\underline{10000}} \quad \underset{e_0}{\underline{00010010}} \quad \underset{e_1}{\underline{10111}} \quad \underset{e_2}{\underline{01110}}$$

Sans modélisation simple de la distribution de l'erreur, il est difficile de déterminer *a priori* la valeur optimale de *S*, et les performances peuvent être considérablement dégradées par un mauvais choix de cette dernière. Comme on ne peut envisager un balayage de toutes les valeurs possibles pour S, on cherche un bon estimateur de cette valeur. L'estimateur *S* retenu est défini de la façon suivante : on appelle *Nb(e)* le nombre de bits qu'occupe un entier positif *e* (hors signe), ou encore la position de son bit de poids fort. Par convention on considère que *Nb(0)*=1.

$$Nb(e) = \begin{cases} 1 \; si \; x = 0 \\ \lfloor \log_2(e) \rfloor + 1 \; si \; x \geq 1, (\lfloor \quad \rfloor \end{cases}$$

désigne l'entier immédiatement inféneur)
On choisit alors:

$$\hat{S} = 2 + arrondi\left(\frac{1}{N}\sum_{k=1}^{N} Nb\left(|E_k|\right)\right),$$

dont le terme final est la moyenne des tailles (en bit) des erreurs de prédiction (en valeur absolue). Cette valeur est partiellement heuristique. Elle a donné le paramètre optimal dans 95 % des cas testés, et sinon une valeur différant d'une unité. On calcule cet estimateur "a la volée", au fur et à mesure de l'arrivée des erreurs.

**Avantages**

Cet algorithme de codage présente les avantages suivants :

- performances en compression : les tests effectués sur les données terrestres (dynamite) produisent, à ordres de prédiction égaux. des résultats meilleurs que ceux des autres méthodes testées, et surtout plus stables, avec des taux de compression situés entre 50 et 70 % (en moyenne aux alentours de 60 %). Pour des données acquises en haute mer (« air guns»), les performances sont légèrement supérieures à celles des autres méthodes, avec des taux compris entre 65 et 90 % . De plus, l'algorithme choisi présente une variabilité plus faible sur un tir donné : l'écart entre les taux de compression extrêmes reste relativement faible ;

- simplicité d'exécution : il comporte peu de paramètres externes à régler ;

- simplicité de codage et de décodage : il suffit de transmettre l'erreur pour recomposer exactement la trace sismique, alors que les algorithmes concurrents requièrent souvent un codage spécifique et la transmission des coefficients de prédiction ; les données transmises sont homogènes ;

- l'algorithme de décodage est presque identique à celui de codage, ce qui simplifie la mise en oeuvre, et les deux travaillent « à la volée » sur les échantillons, au fur et à mesure de leur arrivée ;

- les étapes de l'algorithme de modélisation sont simples et routinières, et les résultats du codage requièrent peu de mémoire ;

- l'algorithme produit ses propres paramètres de codage de l'erreur, si bien qu'il n'est pas nécessaire de pratiquer à cette étape de coûteuses itérations d'optimisation.

**Résultats**

Pour une dizaine de « tirs » donnant lieu chacun à une centaine traces chacun durant deux campagnes d'acquisition sismique, réalisés avec des explosifs (en terrestre) et des canons à air (en manne), chaque trace comprenant chacune 3000 à 4000 échantillons, on a obtenu par exemple les résultats suivants (ordre de prédiction 8) :

|  | Taux moyen | Min./max | Ecart-type |
|---|---|---|---|
| Terrestre | 61 | 49/71 | 6,5 |
| Marine | 75 | 65/90 | 8 |

On a décrit une méthode de codage à un seul seuil S. Bien entendu, on ne sortirait pas du cadre de l'invention en choisissant un codage à plusieurs valeurs seuils distinctes codables respectivement par plusieurs mots de tailles fixes avec évaluation de la taille du mot suffisante pour coder à chaque instant les résidus de prédiction.
Pour améliorer les résultats, il est également possible par exemple :

a) d'augmenter l'ordre de prédiction (jusqu'à 15 par exemple) ;

b) d'affiner la méthode de codage de l'erreur en codant séparément les bits de poids faibles (de 1 à 4) et les bits de poids forts du signal.

**Revendications**

**1.** Méthode de compression sans pertes de signaux à grande dynamique, tels que des signaux sismiques, en vue de leur transmission, comportant l'échantillonnage des signaux et leur numérisation, et l'utilisation d'une technique de codage prédictif avec transmission de coefficients de prédiction et de résidus de prédiction, **caractérisée en ce qu'**elle comporte la détermination d'une plage d'amplitude dépendant d'au moins une valeur seuil (S), qui contient l'essentiel des résidus de prédiction, le codage des résidus de prédiction dans cette plage d'amplitude par des mots binaires ayant un certain nombre n de bits suffisant pour le codage de cette plage, le codage des résidus de prédiction dont l'amplitude est en dehors de la plage, par des mots binaires ayant un nombre fixe de bits supérieur à n, et la transmission des seuls résidus de prédiction.

**2.** Méthode selon la revendication 1, **caractérisée en ce qu'**elle comporte la détermination d'un facteur d'estimation (*S*) d'une valeur-seuil optimale correspondant à une moyenne faite à partir de la position des bits de poids forts respectifs d'une suite de N résidus de prédiction successivement déterminés.

**3.** Méthode selon l'une des revendications précédentes, **caractérisée en ce qu'**elle comporte la détermination de plusieurs plages d'amplitude dépendant de plusieurs valeurs seuils distinctes.

**4.** Méthode selon l'une des revendications précédentes, **caractérisée en ce qu'**elle comporte un codage séparé des bits de poids faibles et des bits de poids forts des échantillons de signaux.

**5.** Méthode selon l'une des revendications précédentes, **caractérisée en ce qu'**elle comporte une détermination des résidus de prédiction pour chaque nouvel échantillon de signal.

**Patentansprüche**

**1.** Verfahren zum verlustfreien Komprimieren von Signalen mit großer Dynamik, wie seismischen Signalen, in Hinblick auf deren Übertragung, umfassend die Probenentnahme der Signale und deren Digitalisierung und die Verwendung einer Vorhersagecodierungstechnik mit Übertragung von Vorhersagekoeffizienten und Vorhersageresiduen, **dadurch gekennzeichnet, dass** es die Bestimmung eines Amplitudenbereichs, abhängig von wenigstens einem das Gros der Vorhersageresiduen umfassenden Schwellenwert (S), die Codierung der Vorhersageresiduen in diesem Amplitudenbereich durch binäre Worte, die eine bestimmte Anzahl n von Bits haben, die ausreichend für die Codierung dieses Bereichs ist, die Codierung der Vorhersageresiduen, deren Amplitude außerhalb des Bereichs liegt, durch binäre Worte mit einer festgelegten Anzahl von Bits größer als n und die Übertragung allein der Vorhersageresiduen umfasst.

**2.** Verfahren nach Anspruch 1, **dadurch gekennzeichnet, dass** es die Bestimmung eines Schätzfaktors ($\hat{S}$) von einem optimalen Schwellenwert umfasst, der einem Mittel entspricht, das aus der Position der Bits mit starken Gewichtungen bezüglich einer Folge von N aufeinanderfolgend bestimmten Vorhersageresiduen gemacht ist.

**3.** Verfahren nach einem der vorhergehenden Ansprüche, **dadurch gekennzeichnet, dass** es die Bestimmung mehrerer Amplitudenbereiche abhängig von mehreren unterschiedlichen Schwellenwerten umfasst.

**4.** Verfahren nach einem der vorhergehenden Ansprüche, **dadurch gekennzeichnet, dass** es eine getrennte Codierung der Bits mit geringen Gewichtungen und der Bits mit starken Gewichtungen der Signalproben umfasst.

**5.** Verfahren nach einem der vorhergehenden Ansprüche, **dadurch gekennzeichnet, dass** es eine Bestimmung der Vorhersageresiduen für jede neue Signalprobe umfasst

**Claims**

**1.** Method for loss-free compression of signals having a wide dynamic range, such as seismic signals, with a view to their transmission, comprising sampling of the signals and digitisation thereof, and the use of a predictive coding method including transmission of prediction coefficients and prediction residues, *characterised in that* it comprises determination of an amplitude range depending on at least one threshold value (S), which contains the essential of the prediction residues, coding of the prediction residues in this amplitude range by binary words having a certain number n of bits sufficient for coding of this range, coding of the prediction residues the amplitude of which lies outside the range, by binary words having a fixed number of bits greater than **n,** and transmission of the prediction residues alone.

**2.** Method according to claim 1, *characterised in that* it comprises determination of a factor ($\hat{S}$) for estimation of an optimum threshold value corresponding to an average established from the position of the respective most significant bits of a series of N successively determined prediction residues.

**3.** Method according to one of the preceding claims, *characterised in that* it comprises determination of a plurality of amplitude ranges depending on a plurality of separate threshold values.

**4.** Method according to one of the preceding claims, *characterised in that* it comprises separate coding of the least significant bits and the most significant bits of the signal samples.

**5.** Method according to one of the preceding claims, *characterised in that* it comprises determination of the prediction residues for each new signal sample.

## FIG.1

## FIG.2

fichier initial

calcul des résidus

compression Huffman

calcul des coefficients

**fichier compressé**

**=**

**résidus compressés**

**+**

**coefficients a(j)**

**FIG.3**

e(0)
e(1)
...
e(T)

décompression Huffman → e(0) e(1) ... e(T)

résidus décompressés

fichier initial
=
résidus compressés

a(1)
a(2)
...
a(p)

Calcul des a(k)

(EQ 2) →

s(0)
s(1)
...
s(T)

fichier final
décompressé

**FIG.4**